# EUROPEAN PATENT SPECIFICATION

(11) **EP 0 475 757 B1**
(45) Date of publication and mention of the grant of the patent: **14.01.1998**
(21) Application number: 91308327.5
(22) Date of filing: 12.09.1991
(51) Int. Cl.: H03K 19/003

(54) **Integrated circuit having reduced sensitivity to voltage transients**
Integrierte Schaltung mit verringerter Empfindlichkeit für Spannungsübergänge
Circuit intégré ayant une sensibilité réduite aux transitions de tension

(30) Priority: 14.09.1990 US 582461
(43) Date of publication of application: 18.03.1992
(73) Proprietor: NCR International, Inc., Dayton, Ohio 45479 (US); HYUNDAI ELECTRONICS AMERICA, Milpitas, California 95035 (US); SYMBIOS LOGIC INC., Fort Collins, Colorado 80525 (US)
(72) Inventor: Steele, David P., Colorado Springs, Colorado 80917 (US)
(74) Representative: Gill, David Alan

(56) References cited:
- US-A- 4 868 627
- US-A- 4 908 528
- US-A- 4 908 528
- PATENT ABSTRACTS OF JAPAN vol. 9, no. 302 (E-362)(2025) 29 November 1985
- PATENT ABSTRACTS OF JAPAN vol. 13, no. 551 (E-857)(3899) 8 December 1989
- PATENT ABSTRACTS OF JAPAN vol. 13, no. 338 (E-795)(3686) 28 July 1989
- PATENT ABSTRACTS OF JAPAN vol. 14, no. 139 (E-903)(4082) 15 March 1990
- JP-A 63 292 647

## Description

The present invention relates to integrated circuits, and has application to input buffers for very large scale integrated (VLSI) circuits.

The trend in the design of integrated circuit chips is for ever smaller geometry sizes and increasingly faster switching times. To further improve system speed, bus widths have been expanded with additional parallel input and output lines. Each output pin on a chip has an output driver which provides a relatively large current in response to a weaker signal generated by the chip. As the load on the bus increases, higher current is provided by the output drivers.

Whenever a logic gate on a chip is switched, as for example a logic gate in an output driver, a transient change in the current is created as the load is charged or discharged. Such transient currents create voltage transients in the power or ground path of the chip. The magnitude of voltage transients increases with increased bus width as additional drivers switch at the same time. Similarly, voltage transients increase as a result of the higher current required to drive larger loads.

Logic gates on the same chip, which share the power or ground paths of the output drivers, are known to switch logic states in response to such power or ground path voltage transients. This creates problems for both output and input drivers. For example, a ground transient or "bounce" can cause a high input to be erroneously recognized as a low level by an input buffer of a chip. An input buffer may include an inverter with series connected pull-up and pull-down transistors. The pull-down transistor has its gate connected to the high input and its source connected to ground. When the ground plane is steady, the gate-to-source voltage (V_{GS}) is large enough to keep the pull-down transistor "on" which keeps the output low. However, the inverter shares a common ground plane with the output drivers on the same chip. If the ground plane bounces as a result of one or more of the outputs switching, V_{GS} decreases, turning off the pull-down transistor, and erroneously switching the output of the inverter. A similar result occurs for the pull-up transistor as a result of a voltage transient on the power supply.

In the past, attempts to prevent the problems associated with power and ground bounce have concentrated on limiting the magnitude of the voltage transient. A typical method of reducing the voltage transient is to slow the rate at which nodes switch. A disadvantage of this approach is that it increases somewhat the propagation delays through an input/output buffer and pad driver. Furthermore, as chips become faster, input buffers become increasingly sensitive to smaller voltage transients. Further reduction of the magnitude of the voltage transient would considerably increase propagation delays through the input/output buffer and pad driver.

US-A 4 908 528 discloses an "add-on" circuitry serving to achieve a reduction in transient-induced noise within an CMOS inverter string by clamping an output signal of an input inverter. This "add-on" circuitry includes an n-type MOS-transistor and a p-type MOS-transistor connected in series between ground and power supply terminals. A capacitor couples a ground transient to the gate of the n-type MOS-transistor. An n-type MOS-transistor provides AC-isolation between the input node and the gate of the first n-type MOS-transistor. A similar structure is shown for the p-type MOS-transistor.

It is an object of the present invention to provide an improved integrated circuit which has reduced sensitivity to voltage transients on reference voltage terminals.

This object is achieved by the integrated circuit according to claim 1.

Embodiments of the present invention will now be described by way of example with reference to the accompanying drawings, in which:
Figure 1 is a prior art input buffer as defined in the preamble of claim 1;
Figure 2 is an input buffer with an inverter according to one embodiment of the present invention;
Figure 3 is an integrated circuit layout of the circuit shown in Figure 2; and
Figure 4 is a Schmitt trigger according to another embodiment of the present invention.

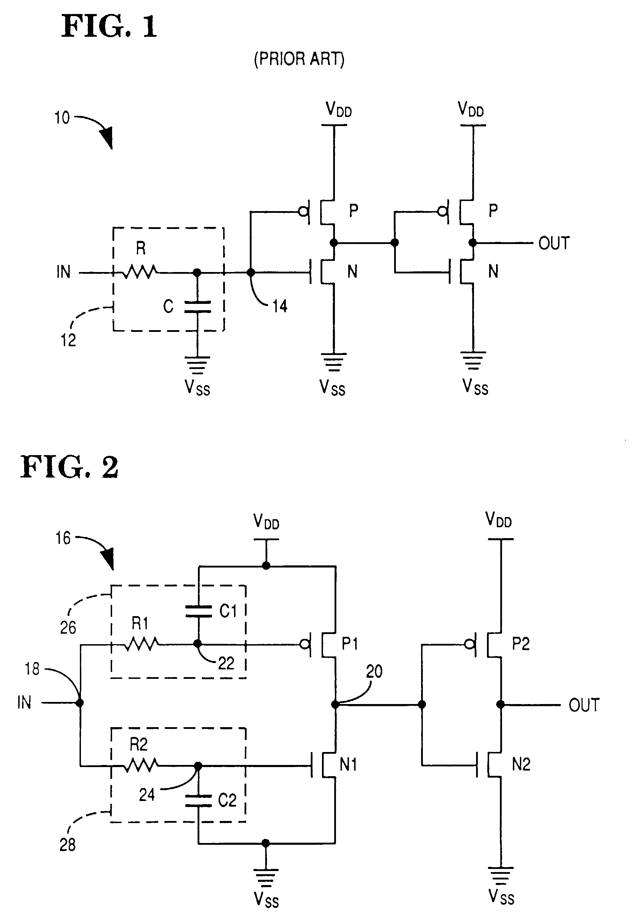

Figure 1 shows a prior art input buffer 10 with a filter 12 for reducing the sensitivity of the buffer 10 to transients on the input line IN. The buffer 10 includes two CMOS inverters, each having complementary PMOS and NMOS field effect transistors P and N, respectively. The filter 12 includes a resistor R connected between the input line IN and the control electrodes of the transistors P and N (node 14) of the first inverter, and a capacitor C connected in series with the resistor R and a reference voltage terminal V_{SS}. The filter 12 is a low pass filter for transients appearing on the input. Thus, high frequency voltage transients on the input do not appear on the node 14. The typical layout of the input filter 12 as an integrated circuit does not provide reduced sensitivity to transients on the ground plane V_{SS}. Irrespective of the layout of the filter 12 vis-a-vis the first inverter, the buffer 10 is also sensitive to transients on the reference voltage terminals V_{DD}.

Figure 2 is an integrated circuit input buffer 16 having reduced sensitivity to voltage transients on the reference voltage terminals V_{DD} and V_{SS}. The buffer 16 includes two CMOS inverters, a first inverter having complementary PMOS and NMOS field effect transistors P1 and N1, respectively, series connected between reference voltage terminals V_{DD} and V_{SS}, and a second inverter having complementary PMOS and NMOS field effect transistors P2 and N2, respectively, similarly series connected between the reference voltage terminals V_{DD} and V_{SS}. The input of the second inverter is connected to an output terminal 20 of the first inverter.

A filter 26 which includes a capacitor C1 and a resistor R1 is connected between an input 18 and the reference voltage terminal V_{DD}. A filter 28 which also includes a capacitor C2 and a resistor R2 is connected between the input 18 and the reference voltage terminal V_{SS}. As will be described more fully, the filters 26 and 28 significantly reduce the sensitivity of the circuit 16 to voltage transients on the voltage terminals V_{DD} and V_{SS}, as well as reducing the sensitivity of the circuit 16 to transients on the input terminal 18. The capacitor C1 is connected between the reference voltage terminal V_{DD} and a node 22, which is connected to the control electrode of the transistors P1. The capacitor C2 is connected between the reference voltage terminal V_{SS} and a node 24 which is connected to the control electrode of the transistor N1. The input terminal 18 is connected to the nodes 22 and 24 through the resistors R1 and R2, respectively. The output terminal 20 of the first inverter is connected to the common point between the transistors P1 and N1 and is further connected to the input of the second inverter (transistors P2 and N2).

The sizing and layout of the resistors R1 and R2, the capacitors C1 and C2, and the transistors P1 and P2 are important features of the present invention. The resistor R1 and the capacitor C1 are sized to form a high pass filter between the reference voltage terminal V_{DD} and the node 22, and to form a low pass filter between the input terminal 18 and the node 22. Similarly, the resistor R2 and the capacitor C2 are sized to form a high pass filter between the reference voltage terminal V_{SS} and the node 24, and to form a low pass filter between the input terminal 18 and the node 24. In a preferred embodiment, for V_{DD} = 5 volts, and V_{SS} = 0 volts, the transistor P1 has a length to width ratio of 5.5, the transistor N1 has a length to width ratio of 20.0, the resistor R1 is 1000 ohms, the capacitor C1 is 1 pf, the resistor R2 is 1000 ohms, and the capacitor C2 is 3 pf.

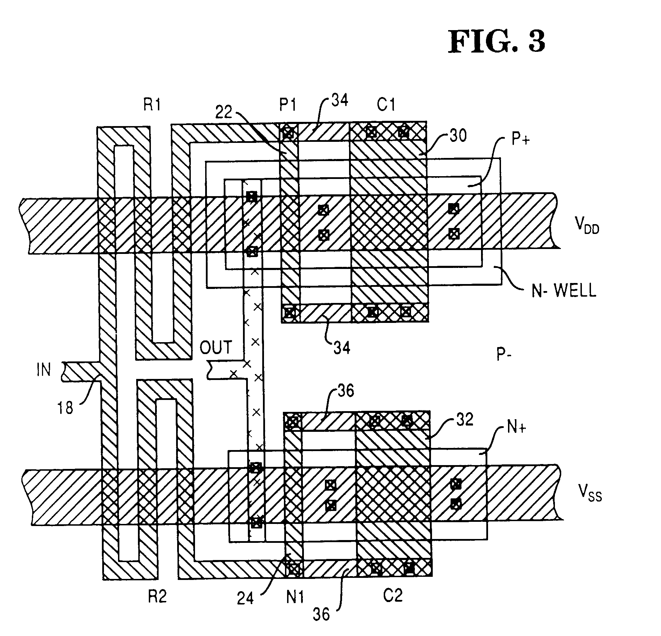

The integrated circuit layout of the resistors R1 and R2, the capacitors C1 and C2, and the transistors P1 and P2 is shown in Figure 3. The gate or control electrode 22 of the transistor P1 is tightly coupled to the capacitor C1 and the resistor R1 to minimize parasitic capacitance and resistance on the electrode 22. Similarly, the gate or control electrode 24 of the transistor N1 is tightly coupled to the capacitor C2 and the resistor R2 to minimize parasitic capacitance and resistance on the electrode 24. In a preferred embodiment, the integrated circuit is laid out on a P-type substrate. The PMOS transistor P1 is formed in a P+ region within an N-well, and the NMOS transistor N1 is formed in an N+ region. The capacitor C1 is formed by the self-alignement of polysilicon layer 30 and the adjacent P+ regions, and the capacitor C2 is formed by the self-alignment of a polysilicon layer 32 and the adjacent N+ regions. It will be appreciated that the capacitor C1 is formed by using the gate capacitance of the PMOS transistor with its source and drain connected to V_{DD}, and the capacitor C2 is formed by using the gate capacitance of the NMOS transistor with its source and drain connected to V_{SS}. Parasitic capacitance on the gate electrode 22 is significantly reduced by connecting the electrode 22 to the capacitor C1 by metallization runs 34. Parasitic capacitance on the gate electrode 24 is significantly reduced by connecting the electrode 24 to the capacitor C2 by metallization runs 36. The resistor R1 is formed by a serpentine polysilicon run between the input node 18 and the electrode 22, and the resistor R2 is formed by a serpentine polysilicon run between the input node 18 and the electrode 24. Parasitic resistance on the gate electrode 22 is significantly reduced by the short metallization runs 34, and parasitic resistance on the gate electrode 24 is significantly reduced by the short metallization runs 36.

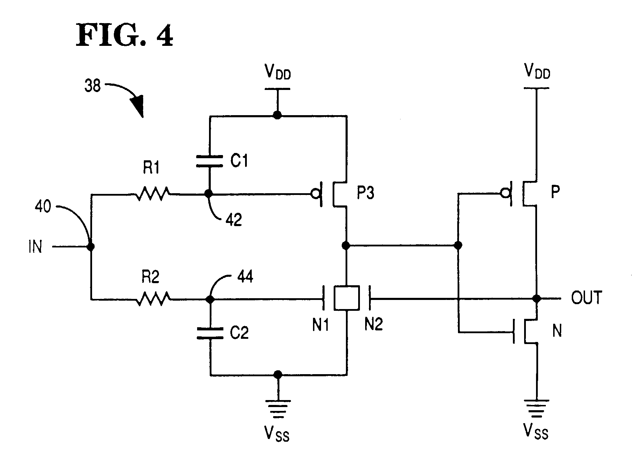

Figure 4 shows an alternative embodiment of the present invention in which the input buffer is a Schmitt trigger 38. The first stage of the Schmitt trigger 38 includes two level sensitive elements: a PMOS transistor P3 and parallel connected transistors N1 and N2. The transistor P3 and the parallel connected transistors N1 and N2 are series connected between the reference voltage terminals V_{DD} and V_{SS}. As with the input buffer 10 shown in Figure 2, the Schmitt trigger 38 includes a capacitor C1 and a resistor R1 connected between the reference voltage terminal V_{DD} and an input 40, and a capacitor C2 and a resistor R2 connected between the reference voltage terminal V_{SS} and the input 40. The common node 42 between the capacitor C1 and the resistor R1 is connected to the control electrode of the transistor P3, and the common node 44 between the capacitor C2 and the resistor R2 is connected to the control electrode of the transistor N1. The layout of the input filters formed by the resistor R1 and the capacitor C1 and the resistor R2 and the capacitor C2 is similar to that shown in Figure 3.

## Claims

1. An integrated circuit including first (N1) and second (P1) complementary transistors series connected between first (V_{SS}) and second (V_{DD}) reference voltage terminals, a first capacitor (C2) connected between said first reference voltage terminal and a control electrode of said first transistor (N1) an input terminal (18) connected to the control electrodes of said first and second transistors for receiving an input signal, and an output terminal (20) connected to the common point between said first and second transistors for providing an output signal derived by way of said first (N1) and second (P1) complementary transistors from the input signal, characterized by a second capacitor (C1) connected between said second reference voltage terminal and a control electrode of said second transistor (P1), whereby the first capacitor is included in a first filter coupled between the input terminal and the first reference voltage terminal, and the second capacitor is included in a second filter coupled between the input terminal and the second reference voltage terminal, said first and second filters being provided for reducing the sensitivity of the circuit to voltage transients on the input terminal and on the first and second reference voltage terminals.

2. An integrated circuit according to Claim 1, characterized by a first resistor (R2) connected between the control electrode of said first transistor (N1) and said input terminal (18), and a second resistor (R1) connected between the control electrode of said second transistor (P1) and said input terminal.

3. An integrated circuit according to Claim 2, characterized in that said first capacitor (C2) and said first resistor (R2) are sized to form a high pass filter between said first reference voltage terminal (V_{SS}) and the control electrode of said first transistor (N1), and to form a low pass filter between said input terminal (18) and the control electrode of said first transistor, and said second capacitor (C1 ) and said second resistor (R1) are sized to form a high pass filter between said second reference voltage terminal (V_{DD}) and the control electrode of said second transistor (P1), and to form a low pass filter between said input terminal (18) and the control electrode of said second transistor.

4. An integrated circuit according to any one of the preceding claims, characterized in that said first (N1) and second (P1) complementary transistors are NMOS and PMOS field effect transistors, respectively.

5. An integrated circuit according to any one of the preceding claims, characterized by an inverter (N2, P2) connected between said first (V_{SS}) and second (V_{DD}) reference voltage terminals and having an input connected to said output terminal (20).

6. An integrated circuit according to any one of the preceding claims, characterized in that said first transistor (N1) is connected in parallel with a third transistor (N2) so as to form a bistable circuit.

7. An integrated circuit according to any one of the preceding claims, characterized in that the control electrode (24) of said first transistor (N1) and said first capacitor (C2) are formed on the same doped region, and the control electrode (22) of said second transistor (P1) and said second capacitor (C1) are formed on the same doped region

8. An integrated circuit according to claim 7, characterized in that the control electrode (24) of said first transistor (N1) is connected to said first capacitor (C2) by metallization (36) so as to reduce the parasitic capacitance on the control electrode of said first transistor, and the control electrode (22) of said second transistor (P1) is connected to said second capacitor (C1) by metallization (34) so as to reduce the parasitic capacitance on the control electrode of said second transistor.

## Patentansprüche

1. Integrierte Schaltung, umfassend einen ersten (N1) und einen zweiten (P1) komplementären Transistor, die zwischen einem ersten (V_{SS}) und einem zweiten (V_{DD}) Referenzspannungsanschluß in Reihe geschaltet sind, wobei ein erster Kondensator (C2) zwischen dem genannten ersten Referenzspannungsanschluß und einer Steuerelektrode des genannten ersten Transistors (N1) geschaltet ist, einen Eingangsanschluß (18), der mit den Steuerelektroden des genannten ersten und des genannten zweiten Transistors zum Empfangen eines Eingangssignals verbunden ist, und einen Ausgangsanschluß (20), der mit dem gemeinsamen Punkt zwischen dem genannten ersten und dem genannten zweiten Transistor zur Erzeugung eines Ausgangssignals verbunden ist, das mittels des genannten ersten (N1) und des genannten zweiten (P1) komplementären Transistors von dem Eingangssignal abgeleitet wurde, gekennzeichnet durch einen zweiten Kondensator (C1), der zwischen dem genannten zweiten Referenzspannungsanschluß und einer Steuerelektrode des genannten zweiten Transistors (P1) geschaltet ist, wobei sich der erste Kondensator in einem ersten Filter befindet, der zwischen dem Eingangsanschluß und dem ersten Referenzspannungsanschluß gekoppelt ist, und wobei sich der zweite Kondensator in einem zweiten Filter befindet, der zwischen dem Eingangsanschluß und dem zweiten Referenzspannungsanschluß gekoppelt ist, wobei der genannte erste und der genannte zweite Filter die Aufgabe haben, die Empfindlichkeit der Schaltung gegenüber Spannungstransienten am Eingangsanschluß und am ersten und zweiten Referenzspannungsanschluß zu reduzieren.

2. Integrierte Schaltung nach Anspruch 1, gekennzeichnet durch einen ersten Widerstand (R2), der zwischen der Steuerelektrode des genannten ersten Transistors (N1) und dem genannten Eingangsanschluß (18) geschaltet ist, und einen zweiten Widerstand (R1), der zwischen der Steuerelektrode des genannten zweiten Transistors (P1) und dem genannten Eingangsanschluß geschaltet ist.

3. Integrierte Schaltung nach Anspruch 2, dadurch gekennzeichnet, daß der genannte erste Kondensator (C2) und der genannte erste Widerstand (R2) so dimensioniert sind, daß sie einen Hochpaßfilter zwischen dem genannten ersten Referenzspannungsanschluß (V_{SS}) und der Steuerelektrode des genannten ersten Transistors (N1) und einen Tiefpaßfilter zwischen dem genannten Eingangsanschluß (18) und der Steuerelektrode des genannten ersten Transistors bilden, und der genannte zweite Kondensator (C1) und der genannte zweite Widerstand (R1) so dimensioniert sind, daß sie einen Hochpaßfilter zwischen dem genannten zweiten Referenzspannungsanschluß (V_{DD}) und der Steuerelektrode des genannten zweiten Transistors (P1) und einen Tiefpaßfilter zwischen dem genannten Eingangsanschluß (18) und der Steuerelektrode des genannten zweiten Transistors bilden.

4. Integrierte Schaltung nach einem der vorherigen Ansprüche, dadurch gekennzeichnet, daß der genannte erste (N1) und der genannte zweite (P1) komplementäre Transistor ein NMOS- bzw. ein PMOS-Feldeffekttransistor sind.

5. Integrierte Schaltung nach einem der vorherigen Ansprüche, gekennzeichnet durch einen Inverter (N2, P2), der zwischen dem genannten ersten (V_{SS}) und dem genannten zweiten (V_{DD}) Referenzspannungsanschluß geschaltet ist und von dem ein Eingang mit dem genannten Ausgangsanschluß (20) verbunden ist.

6. Integrierte Schaltung nach einem der vorherigen Ansprüche, dadurch gekennzeichnet, daß der genannte erste Transistor (N1) parallel zu einem dritten Transistor (N2) geschaltet ist, um eine bistabile Schaltung zu bilden.

7. Integrierte Schaltung nach einem der vorherigen Ansprüche, dadurch gekennzeichnet, daß die Steuerelektrode (24) des genannten ersten Transistors (N1) und der genannte erste Kondensator (C2) auf derselben dotierten Zone ausgebildet sind und die Steuerelektrode (22) des genannten zweiten Transistors (P1) und der genannte zweite Kondensator (C1) auf derselben dotierten Zone ausgebildet sind.

8. Integrierte Schaltung nach Anspruch 7, dadurch gekennzeichnet, daß die Steuerelektrode (24) des genannten ersten Transistors (N1) durch Metallisierung (36) mit dem genannten ersten Kondensator (C2) verbunden ist, um die Parasitärkapazität auf der Steuerelektrode des genannten ersten Transistors zu reduzieren, und die Steuerelektrode (22) des genannten zweiten Transistors (P1) durch Metallisierung (34) mit dem genannten zweiten Kondensator (C1) verbunden ist, um die Parasitärkapazität auf der Steuerelektrode des genannten zweiten Transistors zu reduzieren.

## Revendications

1. Circuit intégré comprenant des premier (N1) et deuxième (P1) transistors séries complémentaires connectés entre des première (V_{SS}) et deuxième (V_{DD}) bornes de tension de référence, un premier condensateur (C2) connecté entre ladite première borne de tension de référence et une électrode de commande dudit premier transistor (N1), une borne d'entrée (18) connectée aux électrodes de commande desdits premier et deuxième transistors pour recevoir un signal d'entrée, et une borne de sortie (20) connectée au point commun entre lesdits premier et deuxième transistors pour délivrer un signal de sortie dérivé par lesdits premier (N1) et deuxième (P1) transistors complémentaires à partir du signal d'entrée, caractérisé par un deuxième condensateur (C1) connecté entre ladite deuxième borne de tension de référence et une électrode de commande dudit deuxième transistor (P1), de sorte que le premier condensateur est compris dans un premier filtre couplé entre la borne d'entrée et la première borne de tension de référence, et le deuxième condensateur est inclus dans un deuxième filtre couplé entre la borne d'entrée et la deuxième borne de tension de référence, lesdits premier et deuxième filtres étant prévus pour réduire la sensibilité du circuit aux transitoires de tension sur la borne d'entrée et sur les première et deuxième bornes de tension de référence.

2. Circuit intégré selon la revendication 1, caractérisé par une première résistance (R2) connectée entre l'électrode de commande dudit premier transistor (N1) et ladite borne d'entrée (18), et une deuxième résistance (R1) connectée entre l'électrode de commande dudit deuxième transistor (P1) et ladite borne d'entrée.

3. Circuit intégré selon la revendication 2, caractérisé en ce que ledit premier condensateur (C2) et ladite première résistance (R2) sont dimensionnés pour former un filtre passe-haut entre ladite première borne de tension de référence (V_{SS}) et l'électrode de commande dudit premier transistor (N1), et pour former un filtre passe-bas entre ladite borne d'entrée (18) et l'électrode de commande dudit premier transistor, et ledit deuxième condensateur (C1) et ladite deuxième résistance (R1) sont dimensionnés pour former un filtre passe-haut entre ladite deuxième borne de tension de référence (V_{DD}) et l'électrode de commande dudit deuxième transistor (P1), et pour former un filtre passe-bas entre ladite borne d'entrée (18) et l'électrode de commande dudit deuxième transistor.

4. Circuit intégré selon l'une quelconque des revendications précédentes, caractérisé en ce que lesdits premier (N1) et deuxième (P1) transistors complémentaires sont des transistors à effet de champ NMOS et PMOS, respectivement.

5. Circuit intégré selon l'une quelconque des revendications précédentes, caractérisé par un inverseur (N2, P2) connecté entre lesdites première (V_{SS}) et deuxième (V_{DD}) bornes de tension de référence et ayant une entrée connectée à ladite borne de sortie (20).

6. Circuit intégré selon l'une quelconque des revendications précédentes, caractérisé en ce que ledit premier transistor (N1) est connecté en parallèle à un troisième transistor (N2) de manière à former un circuit bistable.

7. Circuit intégré selon l'une quelconque des revendications précédentes, caractérisé en ce que l'électrode de commande (24) dudit premier transistor (N1) et ledit premier condensateur (C2) sont formés sur la même région dopée, et l'électrode de commande (22) dudit deuxième transistor (P1) et ledit deuxième condensateur (C1) sont formés sur la même région dopée.

8. Circuit intégré selon la revendication 7, caractérisé en ce que l'électrode de commande (24) dudit premier transistor (N1) est connectée audit premier condensateur (C2) par métallisation (36), de manière à réduire la capacité parasite sur l'électrode de commande dudit premier transistor, et l'électrode de commande (22) dudit deuxième transistor (P1) est connectée audit deuxième condensateur (C1) par métallisation (34), de manière à réduire la capacité parasite sur l'électrode de commande dudit deuxième transistor.
